# EUROPEAN PATENT APPLICATION

(11) **EP 4 513 558 A1**
(43) Date of publication of application: **26.02.2025**
(21) Application number: 24169101.3
(22) Date of filing: 09.04.2024
(51) Int. Cl.: H01L 25/075, H01L 27/15

(54) **DISPLAY DEVICE USING LIGHT-EMITTING ELEMENT**

(30) Priority: 23.08.2023 KR 20230110433
(71) Applicant: LG Electronics Inc., Yeongdeungpo-gu Seoul 07336 (KR)
(72) Inventor: CHANG, Myungwhun, 06772 Seoul (KR); YUN, Okhee, 06772 Seoul (KR); KIM, Wonsik, 06772 Seoul (KR); KIM, Donghyun, 06772 Seoul (KR); SONG, Hongsung, 06772 Seoul (KR); RYU, Byoungson, 06772 Seoul (KR)
(74) Representative: Vossius & Partner Patentanwälte Rechtsanwälte mbB

(57) **Abstract**

A display device using a light emitting device applicable to display device-related technical fields is provided. In a display device implemented by combining a plurality of unit display modules in which a plurality of unit pixel regions is defined, the plurality of unit display modules is combined with each other with an interface therebetween. Each of the unit display modules includes an electrode pad arranged in a unit pixel to define a plurality of unit subpixels, and a light-emitting element electrically connected to the electrode pad. A shortest distance between neighboring pixels including the interface may be greater than a shortest distance between neighboring pixels in the display module.

## Description

### TECHNICAL FIELD

The present disclosure is applicable to display device-related technical fields and, for example, relates to a display device using a light emitting device.

### BACKGROUND

Recently, in a field of a display technology, display devices having excellent characteristics such as thinness, flexibility, and the like have been developed. On the other hand, currently commercialized major displays are represented by a liquid crystal display (LCD) and an organic light emitting diode (OLED).

On the other hand, a light emitting diode (LED), which is a well-known semiconductor light-emitting element that converts electric current into light, has been used as a light source for a display image of an electronic device including an information and communication device along with a GaP:N-based green LED, starting with commercialization of a red LED using a GaAsP compound semiconductor in 1962. Accordingly, a method for solving the above-described problems by implementing a display using the semiconductor light-emitting element may be proposed.

Recently, such light emitting diode (LED) has been gradually miniaturized and manufactured into a micro-sized LED to be used as a pixel of the display device.

When implementing a single large-area display device, raw material costs are relatively high and there is limitation of process equipment and technology. Accordingly, a modular display device that implements the large-area display device by combining several small-sized display modules is being used.

Such a modular display device may have various advantages. For example, large-area display devices of various sizes may be implemented depending on combination of modules. Manufacturing an individual unit display device may be technically easier than manufacturing a single large-area display device. If a problem occurs in part of the display device, repair and replacement may be easy.

However, when implementing one display device by connecting a plurality of unit display devices to each other, problems may arise in operating the unit display devices like a single large-area display device. For example, assembly tolerance may occur. Additionally, optical loss may occur at an interface between modules. Optical loss that may occur at this interface may lead to color changes depending on a viewing angle.

Therefore, a solution to these problems is needed.

### DISCLOSURE

### TECHNICAL PROBLEM

An embodiment of the present disclosure is to provide a display device capable of smoothly implementing color in a modular display device that implements a single display device by connecting a plurality of unit display devices to each other.

An embodiment of the present disclosure is to provide a display device capable of preventing or alleviating an unintended optical phenomenon at an interface between modules in a modular display device.

An embodiment of the present disclosure is to provide a display device capable of preventing or alleviating optical loss that may occur at an interface between modules in a modular display device.

### TECHNICAL SOLUTION

According to one aspect of the present disclosure, there is provided a display device implemented by combining a plurality of unit display modules in which a plurality of unit pixel regions is defined. The plurality of unit display modules is combined with each other with an interface therebetween, and each of the unit display modules includes an electrode pad arranged in a unit pixel to define a plurality of unit subpixels, and a light-emitting element electrically connected to the electrode pad. A shortest distance between neighboring pixels including the interface may be greater than a shortest distance between neighboring pixels in the display module.

In an exemplary embodiment, a distance between the interface and an adjacent subpixel may be greater than a shortest distance between neighboring subpixels in the display module.

In an exemplary embodiment, a distance between the interface and an adjacent subpixel may be greater than half a shortest distance between neighboring pixels in the display module.

In an exemplary embodiment, a pixel pitch including the interface may be equal to or smaller than 1.1 times a pixel pitch in the display module.

In an exemplary embodiment, a pixel pitch including the interface may be 1.05 to 1.1 times a pixel pitch in the display module.

In an exemplary embodiment, an unintended air layer may be located in the interface.

According to another aspect of the present disclosure, there is provided a display device implemented by combining a first display module and a second display module, in which a plurality of unit pixel regions is defined, with an interface therebetween. At least one of the first display module or the second display module includes an electrode pad arranged in a unit pixel to define a plurality of unit subpixels, and a light-emitting element electrically connected to the electrode pad. A distance between the interface and an adjacent subpixel may be greater than a shortest distance between neighboring subpixels in the first display module or the second display module, or may be greater than half a shortest distance between neighboring pixels in the first display module or the second display module.

In an exemplary embodiment, a shortest distance between neighboring pixels including the interface may be greater than a shortest distance between neighboring pixels in the first display module or the second display module.

In an exemplary embodiment, a pixel pitch including the interface may be equal to or smaller than 1.1 times a pixel pitch in the first display module or the second display module.

In an exemplary embodiment, a pixel pitch including the interface may be 1.05 to 1.1 times a pixel pitch in the first display module or the second display module.

In an exemplary embodiment, an unintended air layer may be located in the interface.

In an exemplary embodiment, at least one of the first display module or the second display module may further include a cover layer located on the light-emitting element, and an optical film located on the cover layer.

### ADVANTAGEOUS EFFECTS

According to exemplary embodiments of the present disclosure, the following effects may be obtained.

Color is smoothly implemented in a modular display device that implements a single display device by connecting a plurality of unit display devices to each other.

In addition, an unintended optical phenomenon at an interface between modules in a modular display device is prevented or alleviated.

In addition, optical loss that may occur at an interface between modules in a modular display device is prevented or alleviated.

In addition, even when a viewer observes a display module at an oblique angle upward or downward, there may be no lack of light from a light-emitting element located on the outermost part of the module, so that color fading may not occur, and white light may be normally implemented.

The effects that are achievable by the present disclosure are not limited to what has been particularly described hereinabove and other advantages not described herein will be more clearly understood by persons skilled in the art from the following description.

### BRIEF DESCRIPTION OF THE DRAWINGS

The accompanying drawings, which are included to provide a further understanding of the disclosure and are incorporated in and constitute a part of this application, illustrate embodiment(s) of the disclosure and together with the description serve to explain the principle of the disclosure. In the drawings:
FIG. 1 is a schematic diagram of a display device using a semiconductor light-emitting element according to an embodiment of the present disclosure;
FIG. 2 is a conceptual diagram illustrating an implementation example of a display device using a semiconductor light-emitting element according to an embodiment of the present disclosure;
FIG. 3 is a plan view illustrating an implementation example of a display device using a semiconductor light-emitting element according to an embodiment of the present disclosure;
FIG. 4 is a conceptual diagram illustrating a color implementation example of a modular display device in an ideal case or when an embodiment of the present disclosure is applied;
FIG. 5 is a conceptual diagram illustrating a phenomenon occurring at an interface of a modular display device as a comparative example; and
FIGS. 6 to 8 are conceptual diagrams illustrating the form of light emission according to a distance between an interface and an adjacent subpixel in a modular display device.

### DETAILED DESCRIPTION

Reference will now be made in detail to embodiments of the present disclosure, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions. In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical spirit disclosed in the present specification.

Furthermore, although the drawings are separately described for simplicity, embodiments implemented by combining at least two or more drawings are also within the scope of the present disclosure.

In addition, when an element such as a layer, region or module is described as being "on" another element, it is to be understood that the element may be directly on the other element or there may be an intermediate element between them.

The display device described herein is a concept including all display devices that display information with a unit pixel or a set of unit pixels. Therefore, the display device may be applied not only to finished products but also to parts. For example, a panel corresponding to a part of a digital TV also independently corresponds to the display device in the present specification. The finished products include a mobile phone, a smartphone, a laptop, a digital broadcasting terminal, a personal digital assistant (PDA), a portable multimedia player (PMP), a navigation system, a slate PC, a tablet, an Ultrabook, a digital TV, a desktop computer, and the like.

However, it will be readily apparent to those skilled in the art that the configuration according to the embodiments described herein is applicable even to a new product that will be developed later as a display device.

In addition, the semiconductor light emitting element mentioned in this specification is a concept including an LED, a micro LED, and the like, and may be used interchangeably therewith.

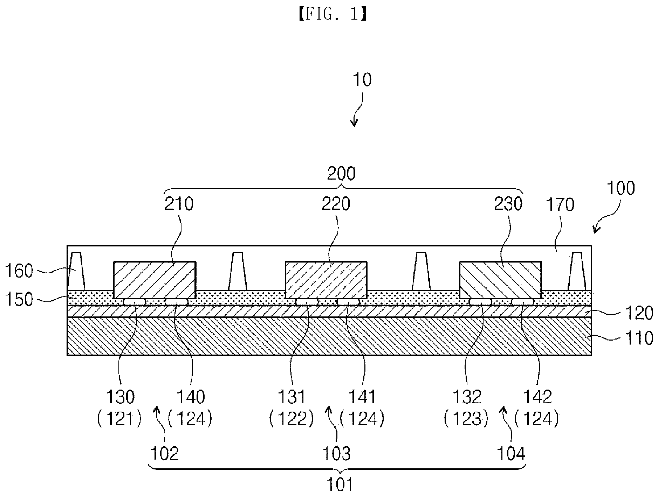

FIG. 1 is a schematic diagram of a display device using a semiconductor light-emitting element according to an embodiment of the present disclosure.

Referring to FIG. 1, a display device 10 has a unit pixel region 101, which is individually divided, on a wiring substrate 100, and light-emitting elements 200 (210, 220, and 230) are respectively installed in a plurality of subpixel regions 102, 103, and 104 positioned in the unit pixel region 101.

Here, the individual light-emitting elements 210, 220, and 230 installed in each unit pixel region 101 may substantially correspond to subpixels. For example, three subpixels may constitute one pixel. In FIG. 1, the three light-emitting elements 210, 220, and 230 may correspond to red, green, and blue light-emitting elements, respectively.

The light-emitting elements 210, 220, and 230 may be electrically connected to a pair of electrode pads 130 and 140, a pair of electrode pads 131 and 141, and a pair of electrode pads 132 and 142, respectively. In this case, for example, the electrode pads 130, 131, and 132 (hereinafter referred to as first electrode pads) arranged in one direction in FIG. 1 are connected to first wiring electrodes 121, 122, and 123 (signal electrodes or data electrodes), respectively.

The electrode pads 140, 141, and 142 (hereinafter referred to as second electrode pads) arranged in the other direction may be connected to a second wiring electrode 124 (a common electrode or a scan electrode). However, the opposite case may also be possible. In FIG. 1, the signal electrodes 121, 122, and 123 and the common electrode 124 are omitted in the arrangement of electrodes and pads.

In some cases, the first electrode pads 130, 131, and 132 may correspond to the signal electrodes 121, 122, and 123, and the second electrode pads 140, 141, and 142 may correspond to the common electrode 124.

Hereinafter, reference numerals for electrode pads and wiring electrodes will be used interchangeably. That is, the electrode pads and the wiring electrodes may be described using the same reference numeral.

Thus, a unit subpixel may be defined at a point at which each of the first wiring electrodes 121, 122, and 123, and the second wiring electrode 124 intersect.

When the first wiring electrodes 121, 122, and 123 are the signal electrodes (or data electrodes), the first wiring electrodes 121, 122, and 123, or the first electrode pads 130, 131, and 132 may be connected to a thin-film transistor (TFT) layer 120 provided with a TFT. Accordingly, the light-emitting elements 210, 220, and 230 may be driven by switching driving by the TFT layer 120.

In FIG. 1, while the TFT layer 120 is schematically shown as one layer, the TFT layer 120 may include multiple TFT regions capable of performing a switching operation. For example, each TFT region includes a gate electrode, a source electrode, a drain electrode, an insulating layer located therebetween, and a via electrode connectable to the first wiring electrodes 121, 122, and 123 (or the first electrode pads 30, 131, and 132). A detailed description thereof will be omitted. These TFT regions may be connected to the light-emitting elements 210, 220, and 230, respectively.

The plurality of light-emitting elements 200 (210, 220, and 230) may be electrically connected to the wiring electrodes 121, 122, 123, and 124 to form individual subpixels.

As described above, the light-emitting elements 200 may include the red light-emitting element 210, the green light-emitting element 220, and the blue light-emitting element 230, and these three light-emitting elements 210, 220, and 230 may constitute individual subpixels and be repeatedly positioned on the wiring substrate 100. These light-emitting elements 210, 220, and 230 may include at least one of an organic LED and an inorganic LED. For example, the light-emitting elements 210, 220, and 230 may be inorganic semiconductor LEDs.

The semiconductor light-emitting element 200 may have a size in micrometers (µm). The micrometer (µm) size may mean that the width of at least one side of the light-emitting element 200 has a size of several micrometers (µm) to hundreds of micrometers (µm).

The TFT layer 120 may be located on the substrate 110, and an insulating layer 150 may be coated on the TFT layer 120. The insulating layer 150 may cover a connection portion between the wiring electrodes 121, 122, 123, and 124, the electrode pads 130, 131, 132, 140, 141, and 142, and the light-emitting elements 210, 220, and 230.

For example, the individual light-emitting elements 210, 220, and 230 may be separated from each other by a barrier wall 160. Additionally, a cover layer 170 may be positioned on the light-emitting elements 210, 220, and 230 and the barrier wall 160.

As described above, the light-emitting elements 210, 220, and 230 may be installed in the individual subpixel regions 102, 103, and 104 to form individual subpixels and may be repeatedly positioned on the wiring substrate 100. For example, each pixel region 101 may be repeatedly arranged on the wiring substrate 100.

In this case, the pixel region 101 may be repeatedly positioned along one line of the data electrodes 121, 122, and 123 (first wiring electrodes) or one line of the scan electrode 124 (second wiring electrode) in a longitudinal direction. For example, in FIG. 1, the red light-emitting element 210, the green light-emitting element 220, and the blue light-emitting element 230 may be repeatedly positioned in a left-right direction. For example, a red light-emitting element in a neighboring pixel region may be located to the right of the blue light-emitting element 230.

Meanwhile, another data electrode (first wiring electrode) line or scan electrode (second wiring electrode) line adjacent to one data electrode (first wiring electrode) line or scan electrode (second wiring electrode) line may be positioned in parallel. In this case, another pixel region 101 of the light-emitting elements 210, 220, and 230, which is arranged identically to the pixel region 101, may be located in an adjacent data electrode (first wiring electrode) line or an adjacent scan electrode (second wiring electrode) line.

In this case, light-emitting elements having the same color may be located adjacent to each other in adjacent pixel regions. For example, while the red light-emitting element 210, the green light-emitting element 220, and the blue light-emitting element 230 are repeatedly formed along the data electrode (first wiring electrode) line or the scan electrode (second wiring electrode) line, light-emitting elements having the same color may be repeatedly positioned in a direction perpendicular to such a data electrode (first wiring electrode) line or scan electrode (second wiring electrode) line.

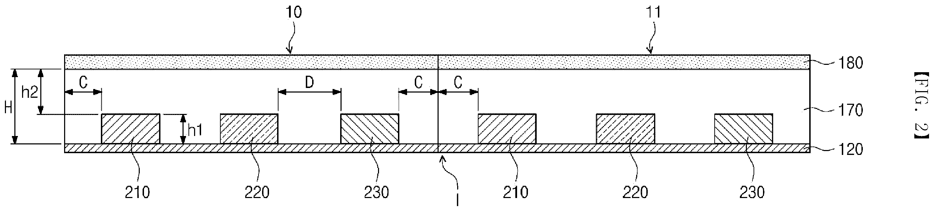

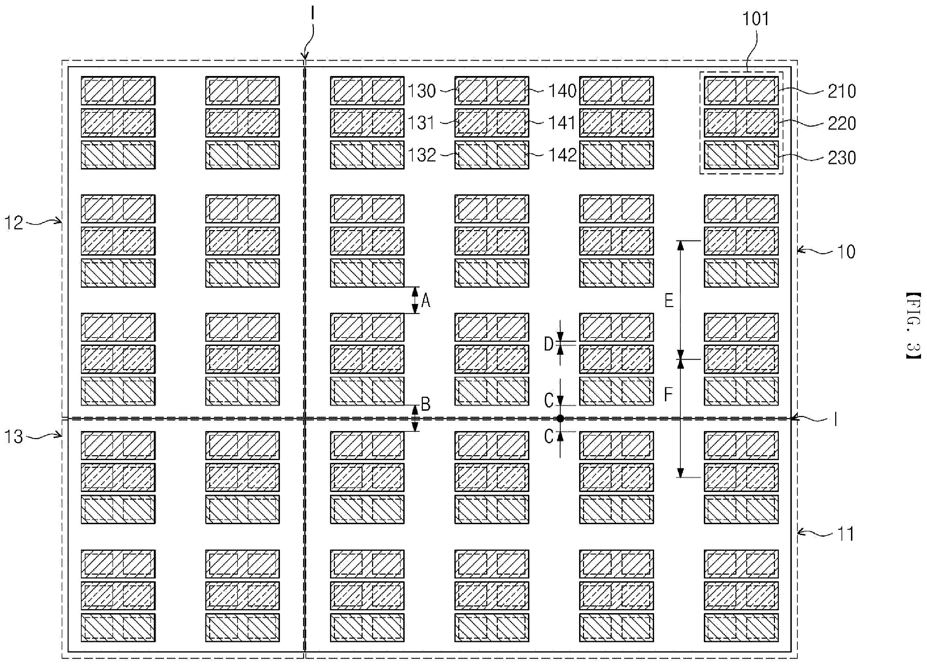

FIG. 2 is a conceptual diagram illustrating an implementation example of a display device using a semiconductor light-emitting element according to an embodiment of the present disclosure. FIG. 3 is a plan view illustrating an implementation example of a display device using a semiconductor light-emitting element according to an embodiment of the present disclosure.

Referring to FIGS. 2 and 3, a display device is shown by combining a plurality of unit display devices 10, 11, 12, and 13 with each other.

One display device may be implemented by connecting the unit display devices 10, 11, 12, and 13 each having a certain size. In this case, each of the unit display devices 10, 11, 12, and 13 may be referred to as a display module. That is, a modular display device may be manufactured by combining the plurality of unit display devices 10, 11, 12, and 13. Hereinafter, a unit display device, and a display module or a module will be described using the same reference numeral.

FIG. 2 shows a state in which two unit display devices 10 and 11 are coupled to each other with sides thereof facing each other. In this case, the sides of the two unit display devices 10 and 11 may face each other to form boundary portions or interfaces I. Ideally, the interfaces I should contact each other without a gap, but in reality, an unintended air layer may be located therebetween due to manufacturing tolerance, etc. The air layer of the interfaces I may cause an unintended change in an optical path between the two modules 10 and 11. For example, a phenomenon such as a change in color of light may occur depending on a change in refractive index between the two modules 10 and 11. Therefore, design elements (technical features) may be required to prevent this phenomenon.

The design elements of these unit display devices 10 and 11 will now be described. The design elements of the individual modules 10 and 11 may include a height h1 of the light-emitting elements 210, 220, and 230, a height h2 of the cover layer 170 excluding the height h1 of the light-emitting elements 210, 220, and 230, and a distance D between the light-emitting elements 210, 220, and 230. Here, the height h2 of the cover layer 170 excluding the height h1 of the light-emitting elements 210, 220, and 230 may be a height excluding the height of an optical layer 180.

Here, since the light-emitting elements 210, 220, and 230 constitute subpixels in each of the modules 10 and 11, the distance D between the light-emitting elements 210, 220, and 230 may correspond to the shortest distance between neighboring subpixels in the modules 10 and 11.

Meanwhile, since the modules 10 and 11 are combined to form a display device, a distance C between the interfaces I of the modules 10 and 11 and adjacent subpixels 210 and 230 may be considered. While FIG. 2 shows an example in which one module includes the three light-emitting elements 210, 220, and 230, this is shown for convenience. For example, as shown in FIG. 3, one module 10, 11, 12, or 13 may include a plurality of light-emitting elements 210, 220, and 230 determined according to an implementation example of the display device as one pixel 101.

Referring to FIG. 3, as an exemplary embodiment, one pixel 101 may include three light-emitting elements 210, 220, and 230. The light-emitting elements 210, 220, and 230 may be electrically connected to a pair of electrode pads 130 and 140, 131 and 141 and 132, and 142, respectively.

In addition, the design elements of each of the modules 10, 11, 12, 13 may include a shortest distance A between neighboring pixels 101 within each of the modules 10, 11, 12, and 13 and a shortest distance B between neighboring pixels 101 including a module interface I.

Here, "A" may correspond to the shortest distance between any two neighboring pixels 101 within each of the modules 10, 11, 12, and 13, and "B" may correspond to the shortest distance between the two neighboring pixels 101 including the module interface I. In other words, "B" may correspond to a value obtained by adding the shortest distance between the two neighboring pixels 101 to an (unintended) spacing of the module interface I.

As described above, "C" may correspond to the distance between the module interface I and an adjacent subpixel. "D" may correspond to the shortest distance between two neighboring subpixels within each of the modules 10, 11, 12, and 13.

Meanwhile, "E" may correspond to a pixel pitch within each of the modules 10, 11, 12, and 13. That is, "E" may correspond to a pixel pitch related to resolution. In FIG. 3, "E" is expressed as the distance between centers of the two neighboring pixels 101. However, "E" may also be expressed as the distance between edges of the two neighboring pixels 101.

Referring to FIG. 3, "F" may correspond to a pixel pitch including the module interface I. In other words, "F" may correspond to a value obtained by adding the distance between centers of the two neighboring pixels 101 to an (unintended) spacing of the module interface I.

The design elements "A" to "F" in such unit display modules or neighboring display modules have exemplarily features as follows.

1. The shortest distance B between the two neighboring pixels 101 including the interface I may be greater than the shortest distance A between the neighboring pixels 101 within each display module (B > A).

2. The distance C between the interface I and an adjacent subpixel may be greater than the shortest distance D between neighboring subpixels in the display module (C > D).

3. The distance C between the interface I and an adjacent subpixel may be greater than half the shortest distance between neighboring pixels in the display module (C > 0.5A).

4. The pixel pitch F including the interface I may be equal to or smaller than 1.1 times a pixel pitch in the display module (F ≤ 1.1E).

5. The pixel pitch F including the interface I may be 1.05 to 1.1 times the pixel pitch within the display module (F = 1.05E to 1.1E).

In this way, in the display device in which the first display module 10 and the second display module 11, in which a plurality of unit pixel regions is defined, are coupled with the interface I therebetween, at least one of Features 1 to 5 described above may be applied. It is apparent that these conditions may also be applied to the other display modules 12 and 13.

For example, the design elements A to F in the first display module 10 and the second display module 11 may have the following features.

6. The distance between the interface I and an adjacent subpixel may be greater than the shortest distance between neighboring subpixels in the first display module 10 or the second display module 11 (C > D) and/or may be greater than half the shortest distance between neighboring pixels in the first display module 10 or the second display module 11 (C > 0.5A).

7. The shortest distance between neighboring pixels including the interface I may be greater than the shortest distance between neighboring pixels in the first display module 10 or the second display module 11 (B > A).

8. The pixel pitch F including the interface I may be equal to or smaller than 1.1 times the pixel pitch in the first display module 10 or the second display module 11 (F <= 1. 1E).

9. The pixel pitch F including the interface I may be 1.05 to 1.1 times the pixel pitch in the first display module 10 or the second display module 11 (F = 1.05E to 1. 1E).

Here, Features 6 to 9 may be substantially the same as Features 1 to 5 described above.

Regarding Feature 1 or Feature 7, in general, B and A may be designed to be the same in order to eliminate the heterogeneity of the interface I between modules. However, in this case, the interface I may appear dark due to optical loss occurring at the interface I. Accordingly, Feature 1 or Feature 7 may be applied to the modular display device.

Meanwhile, when Feature 1 or Feature 7 is applied, the feature may not be suitable depending on the distance between modules (e.g., depending on tolerance). Therefore, in this case, Feature 6, which is a feature excluding tolerance, may be applied. That is, at least one of Feature 2 and Feature 3 may be applied.

When implementing a single large-area display device, raw material costs are relatively high and there are limitations in process equipment and technology. However, the modular display device may have several advantages. For example, large-area display devices of various sizes may be implemented depending on combination of modules. Manufacturing an individual unit display device may be technically easier than manufacturing a single large-area display device. If a problem occurs in part of the display device, repair and replacement may be easy.

However, when implementing one display device by connecting the multiple unit display devices 10, 11, 12, and 13 to each other, there may be various elements to be considered in order for the unit display devices to operate like a single large-area display device. For example, assembly tolerance may occur. Additionally, optical loss may occur at the interface I between modules. Optical loss that may occur at this interface may lead to a change in color depending on a viewing angle of display.

Therefore, when applying these technical features to the display device, an unintended optical phenomenon due to the interface I may be excluded. For example, a phenomenon such as a change in color of light depending on a change in refractive index between the two modules 10 and 11 as described above may be eliminated or alleviated.

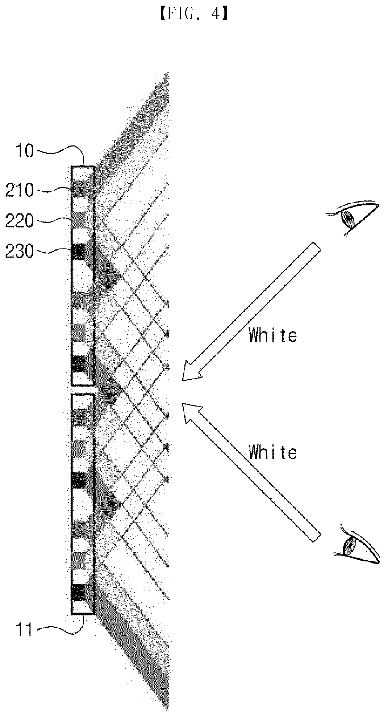

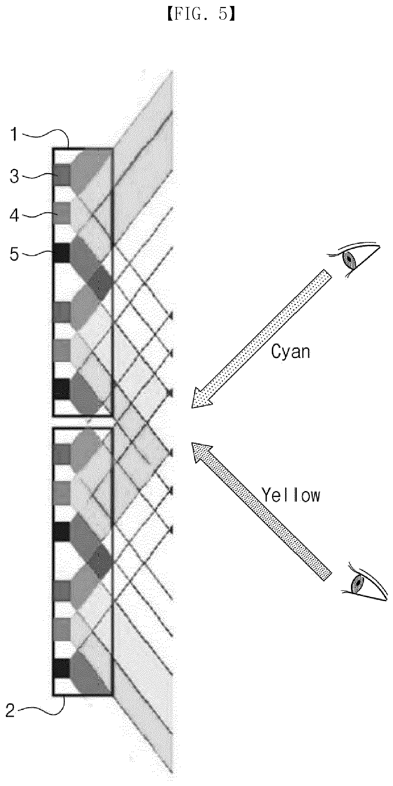

FIG. 4 is a conceptual diagram illustrating a color implementation example of a modular display device in an ideal case or when an embodiment of the present disclosure is applied. FIG. 5 is a conceptual diagram illustrating a phenomenon occurring at an interface of a modular display device as a comparative example.

A description will first be given with reference to FIG. 5. When viewed from above display modules 1 and 2, red light emitted by a red light-emitting element 3, which is the outermost light source, may not be visible at a certain angle. This may be a phenomenon caused by a difference in refractive index at interfaces of the modules 1 and 2. For example, due to a lack of color caused by red light (color fading phenomenon), a color that should appear white may appear cyan (green light + blue light), resulting in a cyan line being visible.

Meanwhile, when viewed from below the display modules 1 and 2, blue light emitted from a blue light-emitting element 5, which is an outer light source, may not be visible at a certain angle. This may be a phenomenon caused by a difference in refractive index at interfaces of the modules 1 and 2. For example, due to lack of color caused by blue light (color fading phenomenon), a color that should appear white may appear yellow (red light + green light), resulting in a yellow line being visible.

However, if at least one of the features of the present disclosure described above is applied, as shown in FIG. 4, even when the display modules 10 and 11 are observed from above or below, there is no deficiency in red light by a red light-emitting element 210 and blue light by a blue light-emitting element 230, so that white light may be normally implemented.

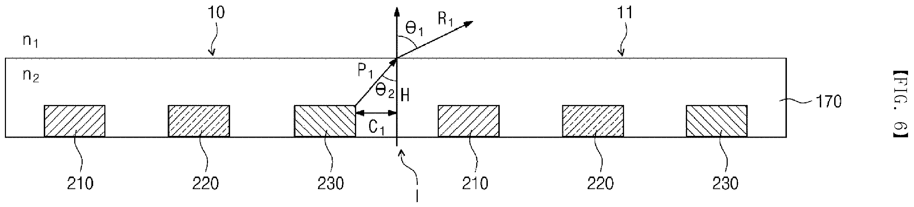

FIGS. 6 to 8 are conceptual diagrams illustrating the form of light emission according to a distance between an interface and an adjacent subpixel in a modular display device.

FIGS. 6 to 8 schematically show paths of incident light and reflected light according to Snell's law. That is, paths of incident light and reflected light according to a distance C between an interface I and an adjacent subpixel in a modular display device are shown.

Snell's law is a law that represents the relationship between angles of incidence, reflection, and refraction when a light ray is obliquely incident on an interface of different media.

Referring to FIGS. 6 to 8, a refractive index inside the display modules 10 and 11 is indicated as n2. As an example, paths of light rays for the refractive index of a cover layer 170 and the refractive index of the outside (in the air) are shown.

FIG. 6 shows the relationship between incident light P1 and refracted light R1 in the case in which a distance C between an interface I between the display modules 10 and 11 and an adjacent subpixel (e.g., a red light-emitting element 230) is C1 which is ideal. In this case, the height of the interface I is H. An incident angle of the incident light P1 is θ2 and a refraction angle of the refracted light R1 is θ1.

In the case of FIG. 6, when the distance between the interface I and a subpixel (e.g., a red light-emitting element 230) adjacent to the interface I is C1, light P1 emitted from an edge of the red light-emitting element 230 located at the outermost part of a module 10 reaches the outer side surface (emission surface) of the module 10 before reaching the interface I or reaches the outer surface (emission surface) between the modules 10 and 11.

Accordingly, the light P1 emitted from the edge of the red light-emitting element 230 does not pass through the interface or is not refracted at the interface I, and is partially refracted at the outer side surface (emission surface) between the modules 10 and 11 or is refracted with a constant refraction angle θ1 to produce refracted light R1. Therefore, even when the display modules 10 and 11 are observed at an oblique angle, color fading may not occur.

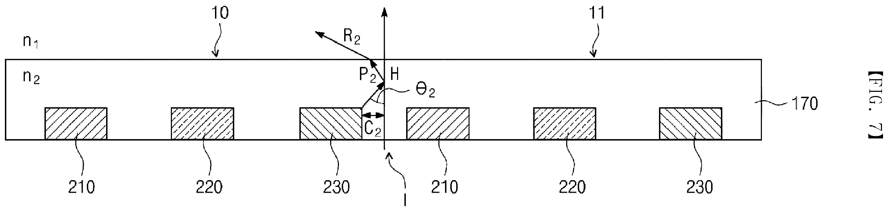

FIG. 7 corresponds to the case in which a distance between an interface I and an adjacent subpixel (e.g., a red light-emitting element 230) is C2, which is smaller than the distance C1 of FIG. 6.

In this case, light P2 emitted from an edge of the red light-emitting element 230 located at the outermost part of a module 10 reaches the interface I before reaching an outer side surface (emission surface) of the module 10. Accordingly, the light P1 emitted from the edge of the red light-emitting element 230 is refracted at the interface I again into the inside of the module 10 and is refracted again at the outer side surface (emission surface) of the module 10 to produce refracted light R2.

In this way, if the distance between a subpixel adjacent to the interface I and the interface I is not sufficient, the light P2 emitted from the edge of the red light-emitting element 230 located at the outermost portion of the module 10 may not be emitted to a neighbor module 11 and may be refracted again and emitted to the module 10. Accordingly, when a viewer observes the display module at an oblique angle, color of a corresponding subpixel may not be visible and color fading may occur.

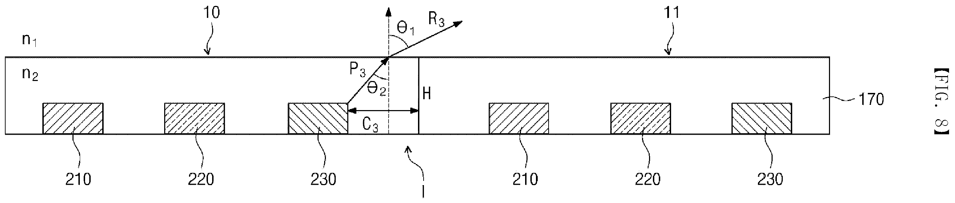

In FIG. 8, a distance between an interface I and an adjacent subpixel (e.g., a red light-emitting element 230) is C3, which is greater than the distance C1 in FIG. 6. For example, FIG. 8 may correspond to the case in which the features described above are applied. In particular, the case of FIG. 8 may correspond to Feature 2, Feature 3, or Feature 6 among the above-described technical features.

In this way, if the distance C3 between the interface I and the adjacent subpixel (e.g., red light-emitting element 230) is sufficiently large, light P3 emitted from an edge of the red light-emitting element 230 located at the outermost part of a module 10 reaches an outer side surface (emission surface) of the module 10 before reaching the interface I.

Accordingly, the light P1 emitted from the edge of the red light-emitting element 230 is partially refracted at the outer side surface (emission surface) between the modules 10 and 11 or is refracted at a constant refraction angle θ1 to produce refracted light R3. Therefore, even when a viewer observes the display modules 10 and 11 at an oblique angle, a color fading phenomenon, which is lack of color, may not occur.

As described above, if at least one of the features of the present disclosure described above is applied, even when a viewer observes the display modules 10 and 11 at an oblique angle upward or downward, there may be no lack of red light emitted by the red light-emitting element 210, located at the outmost part of the module, or blue light emitted by the blue light-emitting element 230. Thus, the color fading phenomenon may not occur and white light may be normally implemented.

Features, structures, effects, and the like as described above in the embodiments are included in at least one embodiment of the present disclosure and should not be limited to only one embodiment. In addition, the features, structures, effects, and the like described in the respective embodiments may be combined or modified even with respect to the other embodiments by those skilled in the art. Accordingly, such combinations and modifications should be construed as within the scope of the present disclosure.

While the present disclosure has been particularly shown and described with reference to exemplary embodiments thereof, these embodiments are only proposed for illustrative purposes and do not restrict the present disclosure, and it will be apparent to those skilled in the art that various changes in form and detail may be made without departing from the essential characteristics of the embodiments set forth herein. For example, respective configurations set forth in the embodiments may be modified and applied.

## Claims

1. A display device implemented by combining a plurality of unit display modules in which a plurality of unit pixel regions is defined,
wherein the plurality of unit display modules is combined with each other with an interface therebetween,
wherein each of the unit display modules comprises:
an electrode pad arranged in a unit pixel to define a plurality of unit subpixels; and
a light-emitting element electrically connected to the electrode pad, and
wherein a shortest distance between neighboring pixels including the interface is greater than a shortest distance between neighboring pixels in the display module.

2. The display device of claim 1, wherein a distance between the interface and an adjacent subpixel is greater than a shortest distance between neighboring subpixels in the display module.

3. The display device of claim 1, or 2, wherein a distance between the interface and an adjacent subpixel is greater than half a shortest distance between neighboring pixels in the display module.

4. The display device of claim 1, 2, or 3, wherein a pixel pitch including the interface is equal to or smaller than 1.1 times a pixel pitch in the display module.

5. The display device of any one of claims 1 to 4, wherein a pixel pitch including the interface is 1.05 to 1.1 times a pixel pitch in the display module.

6. The display device of any one of claims 1 to 5, wherein an unintended air layer is located in the interface.

7. A display device implemented by combining a first display module and a second display module, in which a plurality of unit pixel regions is defined, with an interface therebetween,
wherein at least one of the first display module or the second display module comprises:
an electrode pad arranged in a unit pixel to define a plurality of unit subpixels; and
a light-emitting element electrically connected to the electrode pad, and
wherein a distance between the interface and an adjacent subpixel is greater than a shortest distance between neighboring subpixels in the first display module or the second display module, or is greater than half a shortest distance between neighboring pixels in the first display module or the second display module.

8. The display device of claim 7, wherein a shortest distance between neighboring pixels including the interface is greater than a shortest distance between neighboring pixels in the first display module or the second display module.

9. The display device of claim 7, or 8, wherein a pixel pitch including the interface is equal to or smaller than 1.1 times a pixel pitch in the first display module or the second display module.

10. The display device of claim 7, 8, or 9, wherein a pixel pitch including the interface is 1.05 to 1.1 times a pixel pitch in the first display module or the second display module.

11. The display device of any one of claims 7 to 10, wherein an unintended air layer is located in the interface.

12. The display device of any one of claims 7 to 11, wherein at least one of the first display module or the second display module further comprises:
a cover layer located on the light-emitting element; and
an optical film located on the cover layer.
